# EUROPEAN PATENT APPLICATION

(11) **EP 1 638 205 A1**
(43) Date of publication of application: **22.03.2006**
(21) Application number: 05106483.0
(22) Date of filing: 14.07.2005
(51) Int. Cl.: H03F 3/30

(54) **Driver circuit**

(30) Priority: 16.09.2004 US 942234
(71) Applicant: DEERE & COMPANY, Moline, Illinois 61265-8098 (US)
(72) Inventor: Paulson, John D, West Fargo ND 58078 (US); Boeshans, Brian F., Fargo ND 58102 (US)
(74) Representative: Holst, Sönke

(57) **Abstract**

A driver circuit (10) is connected between an input (12) and an output (14). The driver circuit includes a first stage which includes a first pnp transistor (Q1) and a first npn transistor (Q2). The driver circuit also includes a second stage which includes a second pnp transistor (Q3) and a second npn transistor (Q4). A supply voltage is connected to the emitters of the pnp transistors (Q1 and Q3). A ground potential is connected to the emitters of the npn transistors (Q2 and Q4). The output (14) is connected to the collectors of the second pnp transistor (Q3) and the second npn transistor (Q4). The input (12) is connected to the bases of the first transistors (Q1 and Q2) via resistors (R1 and R2). The collector of the first pnp transistor (Q1) is connected to the base of the second pnp transistor (Q3). The collector of the first npn transistor (Q2) is connected to the base of the the second npn transistor (Q4). The collector of the first pnp transistor (Q1) is connected to the collector of the first npn transistor (Q2) via a resistor (R3). The first stage prevents the second transistors (Q3 and Q4) from being simultaneously in an ON state.

## Description

The present invention relates to a driver/amplifier circuit.

It is often necessary to switch an output at high speeds with a driver circuit. It is common for such driver circuits to have a totem-pole output, which includes a "source" transistor for sourcing current to the output and a "sink" transistor for removing charge from the output. The source and sink transistors may respectively be considered to be part of active pull-up and pull-down circuits. A cross-conduction current or "shoot-through" current can flow when both pull-up and pull-down circuits are both in the ON state. Cross-conduction current results in a relatively large current flow from the power supply wasting energy, causing unwanted heating and supply line pollution and potentially damaging the drive transistors. This "shoot-through" condition can typically occur during the transition between driving a 0 volt output and a 5 volt output.

Various circuits and methods have been employed to prevent "shoot-through", but such circuits and methods have generally been complicated and expensive.

Accordingly, an object of this invention is to provide a simple and inexpensive driver circuit which prevents a "shoot-through" condition.

This and other objects are achieved by the present invention, wherein a driver circuit is connected between an input and an output. The driver circuit includes a first stage which includes a first pnp transistor Q1 and a first npn transistor Q2. The driver circuit also includes a second stage which includes a second pnp transistor Q3 and a second npn transistor Q4. A supply voltage is connected to the emitters of Q1 and Q3. A ground potential is connected to the emitters of Q2 and Q4. The output is connected to the collectors of Q3 and Q4. The input is connected to the bases of Q1 and Q2 via resistors R1 and R2. The collector of Q1 is connected to the base of Q3. The collector of Q2 is connected to the base of Q4. The collector of Q1 is connected to the collector of Q2 via resistor R3. The first stage prevents transistors Q3 and Q4 from being simultaneously in an ON state.

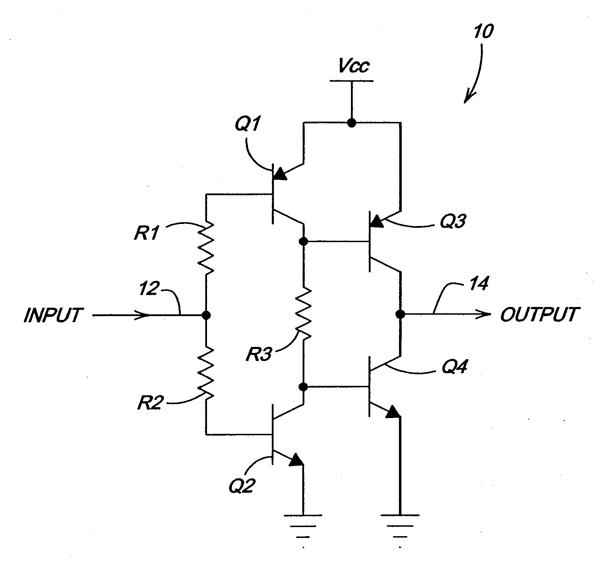

The sole figure is a circuit diagram of driver circuit according to the present invention.

Referring to the Figure, driver circuit 10 includes resistors R1 and R2, each connected between an input 12 and a base of pnp transistor Q1 and npn transistor Q2, respectively. The emitter of transistor Q1 is connected to a supply voltage, Vcc, such as +5 volts. The collector of Q1 is connected to the base of pnp transistor Q3 and to the collector of npn transistor Q2 via resistor R3. The collector of transistor Q2 is also connected to the base of npn transistor Q4. The emitters of Q2 and Q4 are connected to ground. The emitter of transistor Q3 is connected to a supply voltage, Vcc, such as +5 volts. The collectors of Q3 and Q4 are both connected to an output 14. Transistors Q1 and Q2 form a first stage of the driver circuit 10, while transistors Q3 and Q4 form a second stage of the driver circuit. Transistors Q3 and Q4 are in a pnp/npn "totem pole" common emitter configuration. This configuration saturates both transistors and makes possible output voltages very near Vcc and ground potential. Transistors Q3 and Q4 can be either bipolar junction transistors or field effect transistors in a common source configuration.

When voltage at input 12 is 0 volts, transistor Q1 is on (i.e. in saturation), transistors Q2 and Q3 are off and transistor Q4 is on and the voltage at output 14 is low. [01] When the voltage at input 12 reaches approximately 1 to 4 volts, transistors Q1 and Q2 are both on and saturated. The current through the collectors of transistors Q1 and Q2 is limited by R3 so no damage occurs. When both transistors Q1 and Q2 are in saturation, transistors Q3 and Q4 will be turned off. This disconnects output 14 from both Vcc and ground potential, thereby creating a "dead-time" where neither 2^{nd} stage transistor is on and eliminating the shoot-through condition.

When the voltage at input 12 is increased to 5 volts, transistor Q4 remains off, transistor Q1 turns off, allowing transistor Q2 to draw current out of the base of transistor Q3, turning on and saturating Q3, whereby Q3 connects the output 14 to Vcc.

As a result, the driver circuit 10 prevents the "shoot-through" condition, where Q3 and Q4 are both on and are conducting simultaneously, causing large currents and damage to Q3 and Q4. The circuit 10 is a simple low cost digital totem pole driver circuit. The first stage provides signals to the second stage which allows only the following combinations: Q3 on / Q4 off, Q3 off / Q4 off, and Q3 off / Q4 on. These states are all that are required to operate the driver. The driver circuit 10 has a high gain common-emitter configuration which facilitates fast transitions.

## Claims

1. A driver circuit (10) connected between an input (12) and an output (14), the driver circuit (10) comprising:
an input (12) receiving a control signal;
a first pnp transistor (Q1) having a base, collector and emitter;
a first npn transistor (Q2) having a base, collector and emitter;
a second pnp transistor (Q3) having a base, collector and emitter;
a second npn transistor (Q4) having a base, collector and emitter;
a first resistor (R1) connected between the input (12) and the base of the first pnp transistor (Q1);
a second resistor (R2) connected between the input (12) and the base of the first npn transistor (Q2);
a third resistor (R3) connected between the collectors of the first pnp transistor (Q1) and the first npn transistor (Q2);
a first potential source connected to the emitters of the first pnp transistor (Q1) and the second pnp transistor (Q3); and
a second potential source connected to the emitters of the first npn transistor (Q2) and the second npn transistor (Q4), the collector of the first pnp transistor (Q1) being connected to the base of the second pnp transistor (Q3), the collector of the first npn transistor (Q2) being connected to the base of the second npn transistor (Q4), an output (14) being connected to the collectors of the second pnp transistor (Q3) and the second npn transistor (Q4).

2. The driver circuit (10) according to claim 1, wherein:
the first pnp transistor (Q1) and the first npn transistor (Q2) form a first stage, and
the second pnp transistor (Q3) and the second npn transistor (Q4) form a second stage, the first stage preventing the second pnp transistor (Q3) and the second npn transistor (Q4) from being simultaneously in an ON state.
